# FASCICULE DE BREVET EUROPEEN

(11) **EP 1 383 937 B1**
(45) Date de publication et mention de la délivrance du brevet: **27.10.2004**
(21) Numéro de dépôt: 02727687.2
(22) Date de dépôt: 24.04.2002
(51) Int. Cl.: C23C 14/56, B01J 3/02

(54) **DISPOSITIF D'INTRODUCTION D'UN MATERIAU SOUPLE EN BANDE DANS UNE ENCEINTE**
VORRICHTUNG ZUM EINTRAGEN VON WEICHELASTISCHEN BÄNDERN IN EINE KAMMER
DEVICE FOR INSERTING A FLEXIBLE STRIP MATERIAL INTO A CHAMBER

(30) Priorité: 30.04.2001 FR 0105939
(43) Date de publication de la demande: 28.01.2004
(73) Titulaire: Tecmachine, 42160 Andrézieux-Bouthéon (FR)
(72) Inventeur: POIRSON, Jean-Marc, F-42130 SAint Etienne Le Molard (FR); AULAGNER, Michel, F-43330 Saint Ferreol D'auroure (FR); LABALME, Lionel, F-42170 Saint Just Saint Rambert (FR)
(74) Mandataire: Thivillier, Patrick
(86) Numéro de dépôt international: PCT/FR2002/001406
(87) Numéro de publication internationale: WO 2002/088418

(56) Documents cités:
- DE-A- 19 912 707
- PATENT ABSTRACTS OF JAPAN vol. 014, no. 100 (C-0693), 23 février 1990 (1990-02-23) & JP 01 306562 A (NIPPON STEEL CORP;OTHERS: 01), 11 décembre 1989 (1989-12-11)
- PATENT ABSTRACTS OF JAPAN vol. 012, no. 230 (C-508), 29 juin 1988 (1988-06-29) -& JP 63 026365 A (NIPPON KOKAN KK), 3 février 1988 (1988-02-03)

## Description

L'invention se rattache au secteur technique du traitement en atmosphère contrôlée de produits plats et poreux notamment, et trouve une application particulièrement avantageuse lorsque ce traitement est effectué à une pression inférieure à la pression atmosphérique.

Parmi les applications envisagée, on peut citer, d'une manière préférée qui ne doit cependant pas être considérée comme limitative, la métallisation par pulvérisation cathodique en continu de produits plats et poreux, tels que de la mousse de polyuréthane, se présentant sous forme de bande ou de nappe de faible épaisseur.

Plus généralement, l'invention concerne le traitement de tous types de matériaux, sous forme de bandes ou de nappes ayant une structure ouverte ou non, telle que des films en matière plastique, supports textiles, susceptibles d'être soumis à une opération effectuée sous vide.

On connaît des installations servant au traitement continu de bandes métalliques sous vide. Des sas sont placés à l'entrée et à la sortie d'un four servant, par exemple, à la métallisation des bandes métalliques par évaporation sous vide d'un métal ou d'un alliage. Ces différents sas permettent de passer, par étapes successives, de la pression atmosphérique à la pression de travail, et inversement. Cet état de la technique peut être illustré, par exemple, par l'enseignement du brevet FR 2.163.512 où la bande passe successivement entre plusieurs rouleaux placés en rangées parallèles et coopérant avec des sabots fixes d'étanchéité. Ces différents rouleaux et sabots délimitent un certain nombre de compartiments reliés à des pompes à vide, afin de réduire progressivement la pression d'un compartiment à l'autre.
Etant donné que la bande à traiter est métallique, c'est-à-dire présentant une porosité nulle ou quasi nulle, et un degré d'allongement également nul ou quasi nul, il n'y a pas de réels problèmes pour le transfert de la bande d'une manière continue et étanche. Par contre, dans le cadre d'un traitement sous vide notamment d'un matériau présentant un certain degré de porosité, des problèmes importants apparaissent pour pouvoir traiter en continu ce type de matériau au niveau du maintien, compte tenu de sa relative souplesse et de l'étanchéité compte tenu de sa porosité.

L'invention s'est fixée pour but de remédier à ces inconvénients, de manière simple, sûre, efficace et rationnelle.

Le problème que se propose de résoudre l'invention est de permettre notamment le passage en continu d'une bande ou nappe de matériau souple, depuis la pression atmosphérique jusqu'à une pression de travail, d'une manière parfaitement étanche, en considérant que le champ d'application de l'invention concerne également les cas où les pressions étant égales à l'intérieur et à l'extérieur de l'enceinte, il est nécessaire de maintenir une étanchéité dynamique entre ces deux milieux par exemple pour respecter et contrôler des compositions particulières des atmosphères de part et d'autre de la paroi.

Dans la suite de la description et par souci de clarté, on limitera la description au cas où l'invention a pour but de garantir une différence de pression, mais il est bien entendu qu'elle s'applique également au cas où elle garantit une différence de composition à pressions égales.

Pour résoudre un tel problème, il a été conçu et mis au point un dispositif qui comprend des moyens aptes à assurer, en continu, le transfert et la mise en compression du matériau, d'une manière contrôlée, sans glissement et sans étirement, avec maîtrise de l'étanchéité dynamique à l'intérieur d'une enceinte.

Les moyens de transfert et de mise en compression du matériau sont constitués par des bandes transporteuses disposées en regard, en délimitant un espace où est engagé à plat le matériau.

Au moins les deux faces en regard de chacune des bandes présentant une série de cannelures identiques et régulièrement espacées pour être imbriquées en vue d'assurer, d'une manière concomitante, l'étanchéité dynamique dudit matériau sous l'effet de l'imbrication.

Avantageusement, chacune des face des bandes présentent des cannelures.

Il est apparu, de façon préférentielle, mais non limitative, qu'une compression exercée sur le matériau, afin d'augmenter sa densité, permet d'obtenir une meilleure étanchéité dynamique, au fur et à mesure du transfert en continu.

Compte tenu de ces dispositions, il en résulte que les bandes cannelées qui font office de courroies crantées, assurent un parfait synchronisme d'entraînement en immobilisant et en contrôlant, d'une manière positive, le matériau pendant son transfert, tout en permettant d'augmenter la longueur des fuites artificiellement.

Pour résoudre le problème posé d'assurer l'entraînement linéaire des bandes cannelées en vue du transfert concomitant du matériau inséré entre les cannelures des deux faces en regard des bandes délimitant l'espace, lesdites bandes cannelées coopèrent avec des organes d'entraînement en rotation pour être déplacées linéairement, d'une manière continue.

Avantageusement, les organes d'entraînement sont constitués, pour chacune des bandes, par des rouleaux de mise en tension montés libres en rotation et par des rouleaux cannelés assujettis à des moteurs avec capacité d'indexation et de synchronisation.

Pour résoudre le problème posé de contrôler l'étanchéité, les bandes coopèrent avec un tunnel de guidage présentant une sole fixe et une sole réglable pour faire varier, d'une manière correspondante, la pression d'écrasement exercée sur le matériau sous l'effet de l'imbrication des cannelures.

Le dispositif trouve une application avantageuse, notamment dans le cas d'une installation de traitement sous vide pour une opération de métallisation par pulvérisation cathodique en continu d'un matériau passant en continu de la pression atmosphérique jusqu'à la pression de travail, l'installation étant par exemple constituée de plusieurs modules ou étages alignés faisant office de sas et assujettis chacun à des moyens d'aspiration pour obtenir successivement, une pression décroissante.

A partir de cette conception de base et dans une forme de réalisation donnée à titre indicatif, nullement limitatif, l'installation peut être constituée :
- d'une enceinte fermée à partir de laquelle est introduit le matériau à la pression atmosphérique, ladite enceinte étant portée à une pression déterminée, et recevant, d'une manière permettant une étanchéité contrôlée, les moyens de transfert et de mise en compression dudit matériau ;
- un module tampon avec rouleaux de guidage du matériau, ledit module étant porté à la même compression que l'enceinte ;
- au moins un module intermédiaire ;
- au moins un module, avec rouleaux de guidage et d'entraînement, relié au poste de traitement ;
- l'enceinte et les différents modules étant agencé pour permettre le montage et le guidage des moyens de transfert et de mise en compression, d'une manière étanche.

L'invention est exposée ci-après plus en détail à l'aide des figures des dessins annexés dans lesquels :

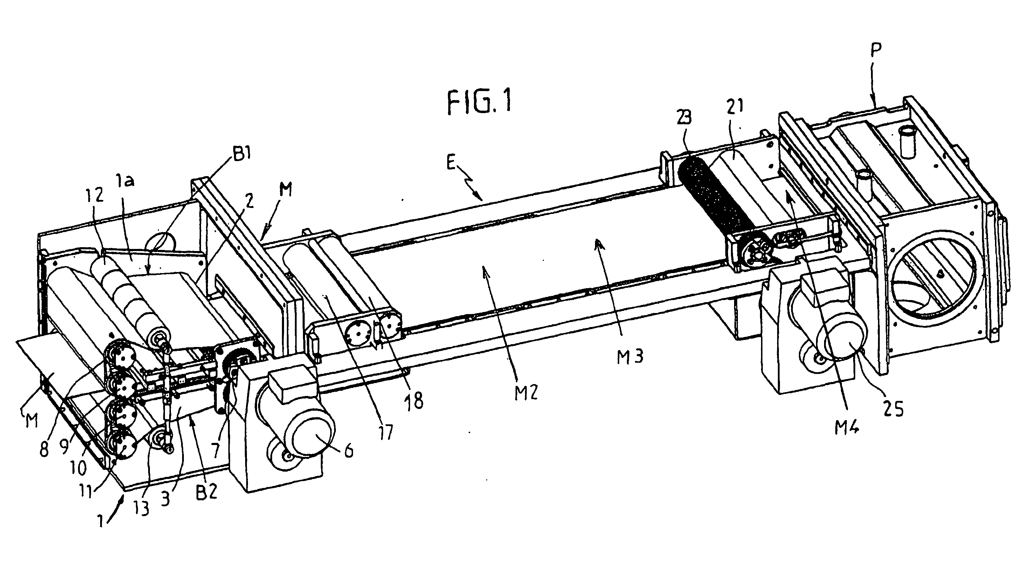

- la figure 1 est une vue en perspective montrant une application du dispositif selon les caractéristiques de l'invention à une installation de traitement sous vide en continu ;
- la figure 2 est une vue en coupe, à caractère schématique et à grande échelle, montrant le principe des moyens de transfert en continu et de mise en compression du matériau, d'une manière contrôlée, sans glissement et sans étirement, avec maîtrise de l'étanchéité dynamique ;
- la figure 3 est une vue à caractère purement schématique montrant un exemple d'installation susceptible de mettre en oeuvre le dispositif selon l'invention ;

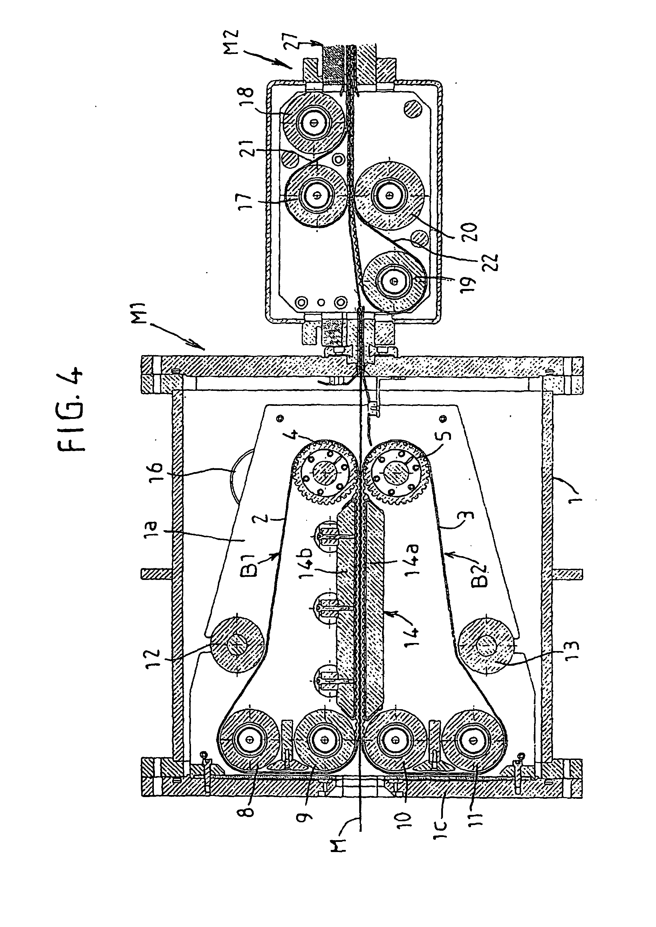

- la figure 4 est une vue partielle et en coupe d'une partie de l'installation montrant un module avec les moyens de transfert et de mise en compression, et à partir duquel le matériau à traiter, soumis à la pression atmosphérique, est engagé ; dans cet exemple, ce module est relié à un module tampon de transfert, soumis à la même pression interne, et relié à une filière ;

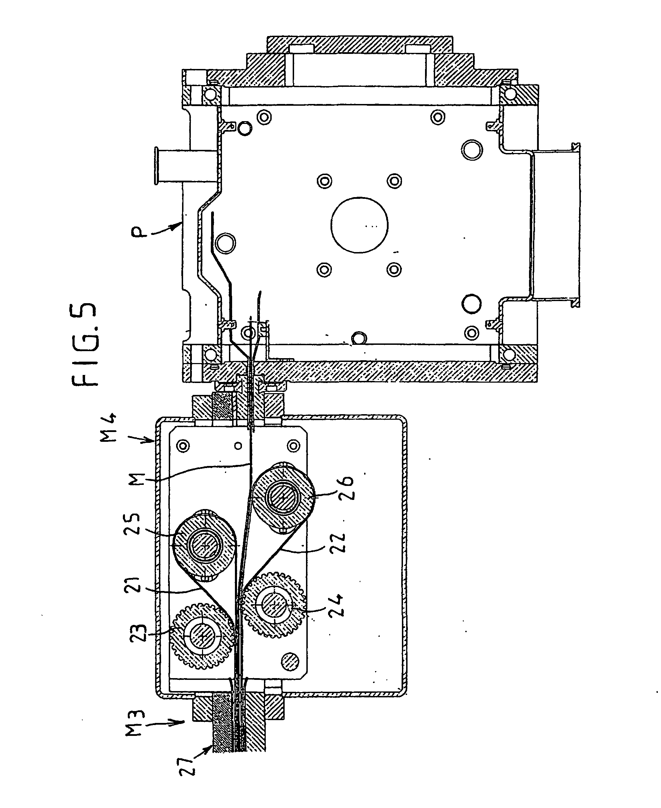

- la figure 5 est une vue en coupe montrant la connexion de la filière au poste de traitement par l'intermédiaire d'un module d'entraînement du matériau ;

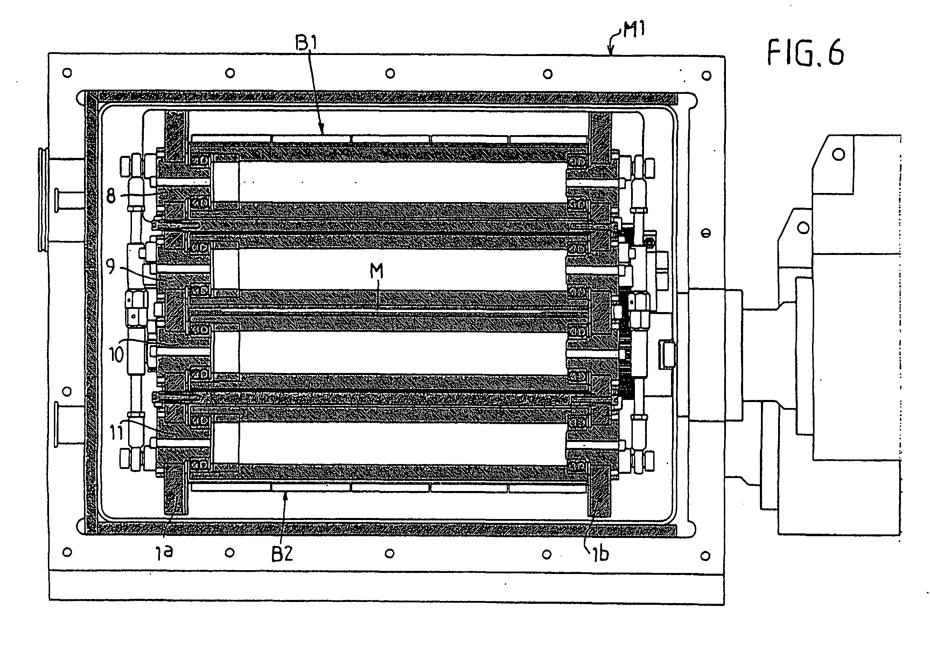

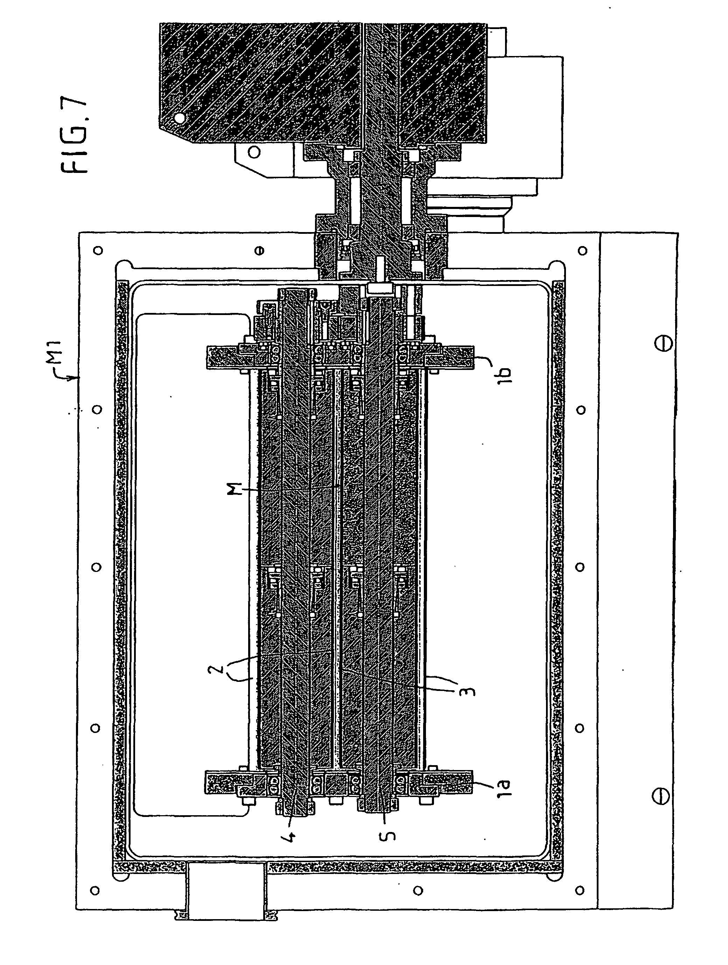

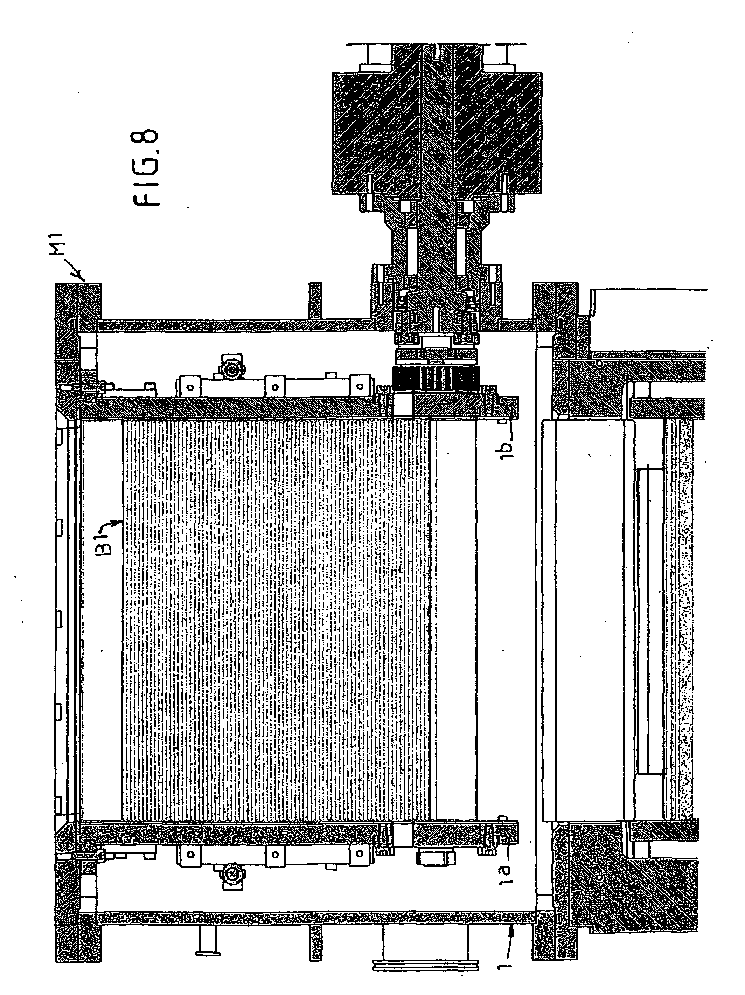

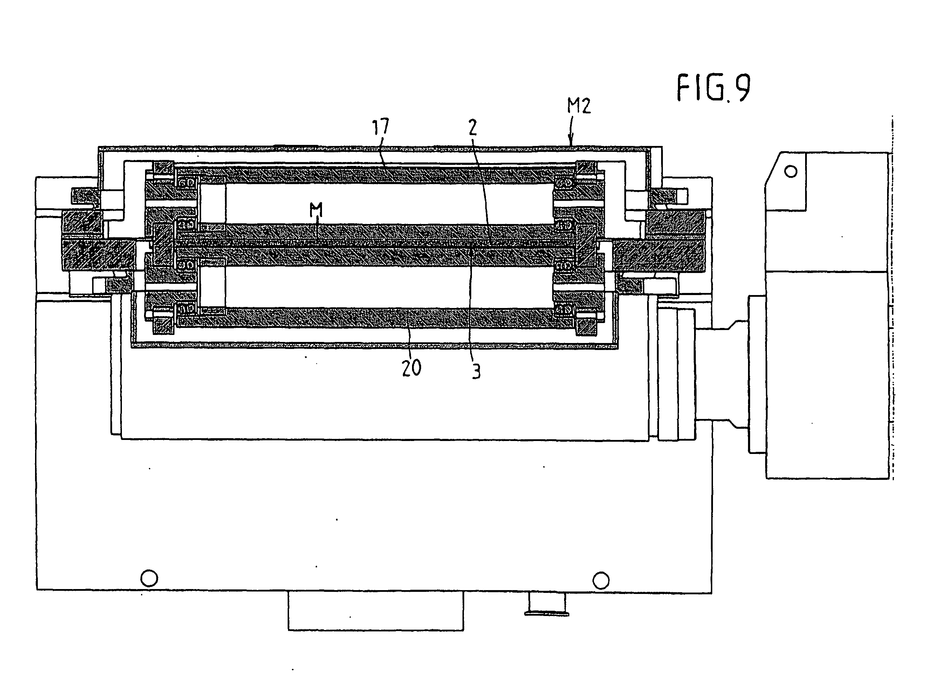

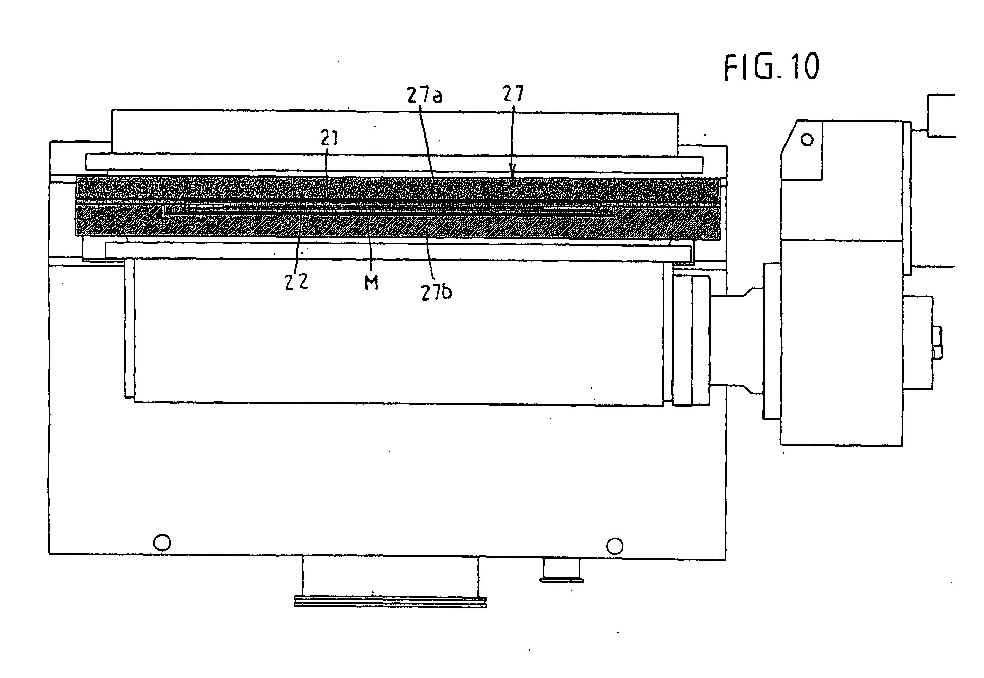

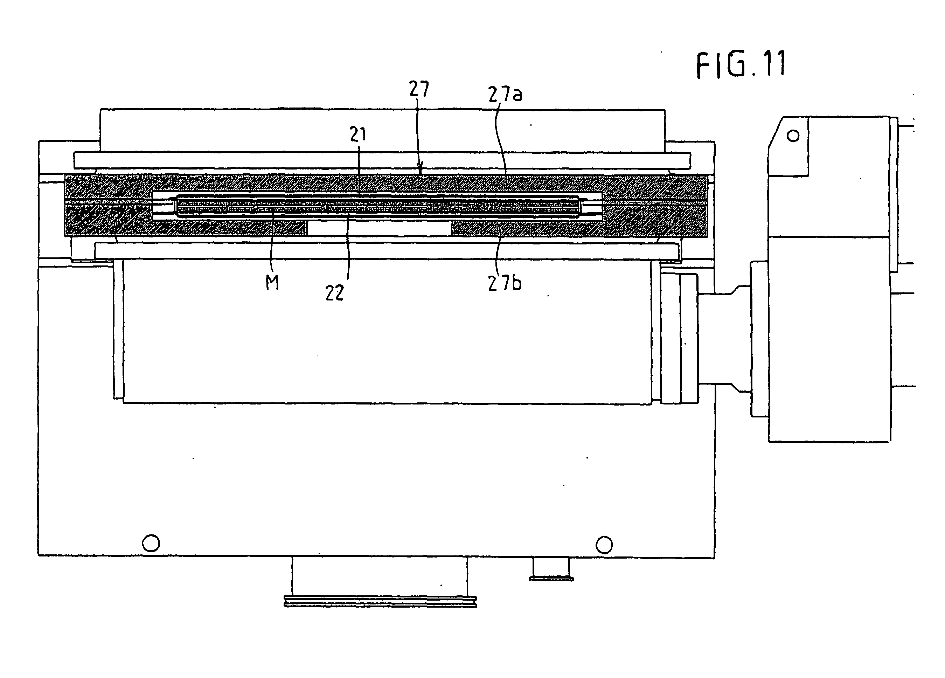

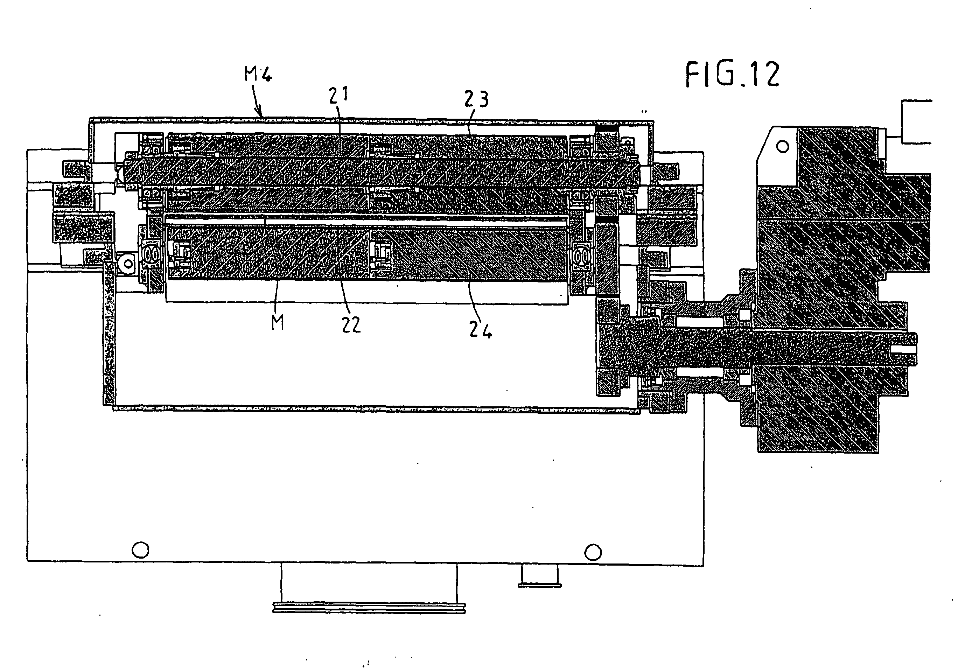

- les figures 6, 7, 8, 9, 10, 11 et 12 sont des vues en coupe, à une échelle plus importante, considérées respectivement selon les lignes A-A, B-B, C-C, D-D, E-E, F-F et G-G de la figure 3.

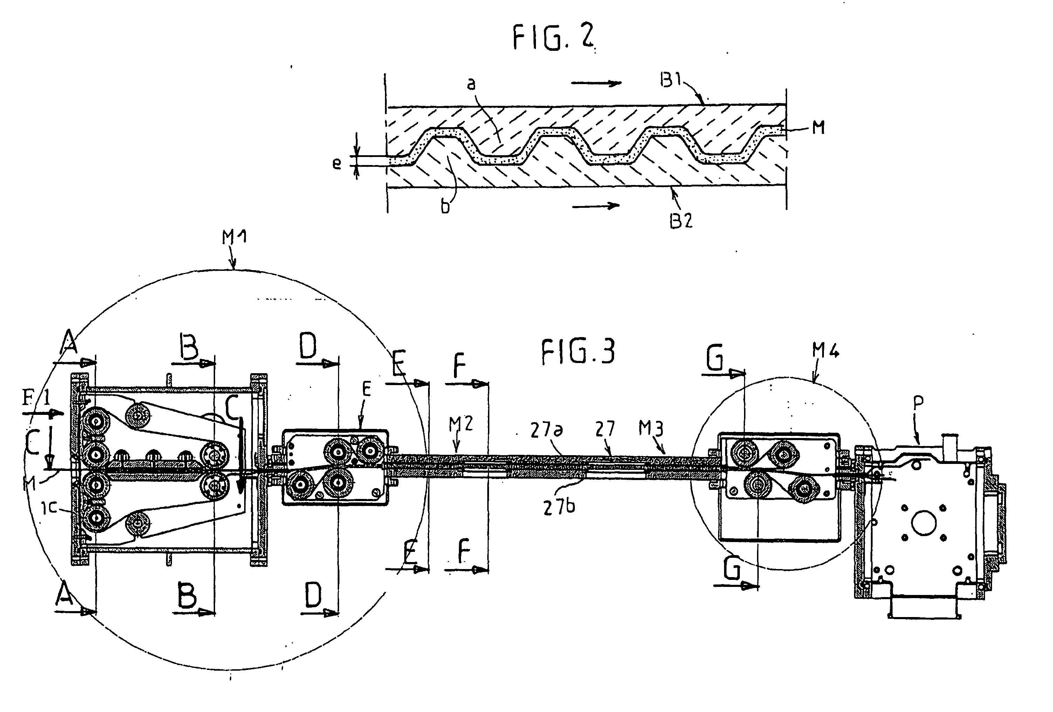

Comme indiqué, le dispositif selon l'invention trouve une application particulièrement avantageuse pour le traitement sous vide d'un matériau souple, notamment en bande ou en nappe, tel que de la mousse de polyuréthane. On désigne par (M) ce matériau, quelle que soit sa structure.
Par exemple, l'installation de traitement peut comprendre au moins un ensemble fermé (E) assujetti à des moyens d'aspiration du type pompe à vide pour obtenir, depuis la pression atmosphérique (Pa), une pression décroissante jusqu'à la pression de travail, au niveau d'un poste de traitement (P).
Par exemple, comme le montre schématiquement la figure 3, l'ensemble (E) peut être constitué de plusieurs modules (M1), (M2), (M3) et (M4) assujettis chacun à des moyens d'aspiration pour obtenir successivement une pression décroissante. Par exemple, le module (M1) est soumis à une pression (P₁) de 100 Pa, le module (M2) à une pression (P₂) de 10 Pa, le module (M3) à une pression (P₃) de 1 Pa, et le module (M4) à une pression de 0,1 Pa.

Selon l'invention, le dispositif comprend, à l'intérieur de l'ensemble (E), des moyens aptes à assurer, en continu, depuis la pression atmosphérique jusqu'au poste de traitement (P) à la pression de travail souhaitée, le transfert et la mise en compression du matériau (M), d'une manière contrôlée, sans glissement et sans étirement, avec maîtrise de l'étanchéité dynamique.

Selon une réalisation préférée et particulièrement avantageuse, les moyens de transfert en continu sont constitués par deux bandes transporteuses ou série de bandes transporteuses, (B1) et (B2), disposées dans deux plans parallèles, en regard l'une de l'autre, en délimitant un espace (e) dans lequel est engagée à plat et mise en compression la nappe de matériau (M). D'une manière importante, au moins les deux faces en regard de chacune des bandes (B1) et (B2), présentent des séries de cannelures, de préférence identiques, et régulièrement espacées (a) et (b).
Dans l'espace (e) correspondant au chevauchement des faces en regard de chacune des bandes, les cannelures (a) et (b) sont imbriquées afin d'assurer, d'une manière concomitante, l'étanchéité dynamique du matériau (M), sous l'effet de la compression exercée correspondant à un écrasement contrôlé du matériau.

Les cannelures (a) et (b) de chacune des bandes (B1) et (B2) sont disposées parallèlement les unes aux autres, les bandes étant orientées, de sorte que lesdites cannelures sont disposées perpendiculairement au sens du défilement de la nappe de matériau (M), c'est-à-dire perpendiculairement à ses côtés longitudinaux, étant rappelé que le matériau se présente sous forme d'une nappe de très grande longueur.

Avantageusement, chacune des faces des bandes transporteuses (B1) et (B2) présente des cannelures.

Les bandes cannelées (B1) et (B2) coopèrent avec des organes d'entraînement en rotation pour être déplacées linéairement, d'une manière continue, comme il sera indiqué dans la suite de la description, à l'aide des exemples de réalisation illustrés. Les organes d'entraînement sont constitués pour chacune des bandes (B1) et (B2) par des rouleaux de renvoi et de mise en tension montés libres en rotation et par des rouleaux cannelés assujettis à un ensemble moteur avec capacité d'indexation et de synchronisation. On observe, à cet égard, que les bandes, ou séries de bandes (B1) et (B2), constituent des courroies crantées.

Bien évidemment, compte tenu du problème posé d'assurer l'étanchéité au fur et à mesure du déplacement en continu de la nappe de matériau (M), sous l'effet de l'entraînement des courroies (B1) et (B2), ces dernières coopèrent avec des agencements internes que présente l'ensemble (E) et aptes à assurer une parfaite étanchéité dudit matériau.

Dans l'exemple de réalisation illustré, l'ensemble (E) comprend une enceinte (1) et plusieurs modules ou sas (M1), (M2), (M3) et (M4).

Dans l'enceinte fermée (1) à partir de laquelle est introduite la nappe de matériau (M) à la pression atmosphérique, la série de bandes cannelées (B1) et (B2) est constituée par deux courroies crantées (2) et (3). Comme indiqué précédemment, chacune des faces des courroies (2) et (3) présente des cannelures parallèles, d'une part, pour leur entraînement en synchronisme et, d'autre part, pour l'entraînement de la nappe de matériau (M), comme indiqué précédemment.
Par exemple, les courroies (2) et (3) coopèrent, à l'une de leurs extrémités, du côté de leur face interne, avec un rouleau cannelé (4) et (5) entraîné positivement en rotation et en synchronisme par un organe moteur commun (6) avec système d'indexation (7). A l'autre extrémité, chacune des courroies (2) et (3) coopère avec des rouleaux étagés de renvoi (8-9) et (10-11) disposés en alignement. De même, les courroies (2) et (3) peuvent coopérer avec des moyens de mise en tension (12) et (13).

Les parties des bandes (2) et (3) disposées en regard pour délimiter l'espace (e), dans la position d'imbrication des cannelures, coopèrent avec un tunnel de guidage (14) présentant une sole fixe (14a) et une sole (14b) assujettie à des moyens de réglage (15) pour faire varier d'une manière correspondante et contrôlée l'espace (e) en vue de régler, de manière concomitante, la pression d'écrasement exercée sur la nappe de matériau logée entre lesdites cannelures imbriquées.

Comme indiqué précédemment, l'enceinte (1) est reliée en (16) à un moyen d'aspiration pour être soumise à une pression interne (P₁) déterminée inférieure à la pression atmosphérique (Pa). Par exemple, comme indiqué, la pression (P₁) est de 100 Pa.

A l'intérieur de l'enceinte (1), pour assurer une parfaite étanchéité du matériau (M), les bords latéraux des courroies (2) et (3) coopèrent en appui avec des flasques verticaux (1a) et (1b) qui peuvent être équipés directement, ou d'une manière rapportée, d'un revêtement apte à assurer le glissement des courroies sans risque de détérioration. De même, l'enceinte (1) est obturée par une porte (1c) présentant une fente pour l'introduction du matériau (M). Sur la face interne de cette porte est bridée une plaque réalisée dans un matériau étanche pour l'appui facial avec capacité de glissement de la partie correspondante des courroies (2) et (3). A noter que l'un des flasques (1a) est fixe tandis que l'autre (1b), est monté avec capacité de réglage.

L'enceinte (1) est accouplée, d'une manière étanche, à une filière ou tunnel de guidage (27) délimitant les différents modules (M1), (M2), (M3) et (M4).
Le module (M1) est soumis à la même pression interne (P1) et présente, intérieurement, des rouleaux de guidage et de mise en tension (17, 18) et (19, 20), de deux autres séries de bandes (B1) et (B2) se présentant sous forme de courroies (21) et (22) convenablement disposées en superposition, de manière à délimiter, comme précédemment, l'espace (e) jusqu'au poste de traitement (P) pour le transfert et la mise en compression de la nappe de matériau, de manière contrôlée, sans glissement et sans étirement, avec maîtrise de l'étanchéité dynamique.

A la sortie du module tampon (M2), les brins de chacune des courroies crantées (21) et (22), sont superposés. Les faces en regard qui sont imbriquées en délimitant l'espace (e), sont engagées, d'une manière étanche, entre deux platines (27a) et (27b) du tunnel de guidage (27). Les modules (M2) et (M3) sont reliés chacun à des moyens d'aspiration pour être soumis à une pression interne différente. Par exemple, on rappelle, comme indiqué, que le module (M2) est soumis à une pression (P₂) de 10 Pa, tandis que le module (M3) est soumis à une pression (P₃) de 1 Pa. Bien évidemment, le nombre de modules constituant la filière est donné à titre indicatif, nullement limitatif.

A la sortie, la filière ou tunnel (27) reçoit d'une manière étanche, le module (M4) sous forme d'un boîtier conformé pour assurer le transfert du matériau, dans les conditions indiquées précédemment, au poste de traitement (P). Ce module (M4) présente intérieurement des rouleaux cannelés d'entraînement (23) et (24) accouplés à un organe moteur commun (25) pour être entraînés en synchronisme. Ces rouleaux cannelés (23) et (24) assurent l'entraînement positif des courroies (21) et (22), en combinaison avec des rouleaux de renvoi et de mise en tension (25) et (26). Les courroies (21) et (22) sont donc assujetties à l'ensemble des rouleaux (17-18-23-25) et (19-20-24-26).

Au niveau du tunnel (27), l'étanchéité des courroies (21) et (22) est assurée, par exemple, par un joint monté sur la platine fixe (27a).

Comme indiqué, le poste (P) est agencé, avec tout moyen connu et approprié, pour assurer le traitement que l'on souhaite réaliser sur la nappe de matériau.
Dans le cas d'une application de l'installation à une mousse de polyuréthane, d'épaisseur d'environ 1,6 mm et devant être soumise à une opération de prémétallisation, on a observé qu'un espace (e) déterminé pour soumettre la nappe de matériau à une épaisseur de 0,4 mm, est un bon compromis. Les différences d'étanchéité entre la mousse pure, c'est-à-dire avant prémétallisation et après prémétallisation, sont négligeables.

On rappelle que l'exemple d'application du dispositif à une installation de traitement sous vide avec un certain nombre de modules ou de sas, est donné à titre indicatif nullement limitatif et dépend notamment de la nature du matériau à traiter et du traitement auquel il doit être soumis.

Les avantages ressortent bien de la description, en particulier on souligne et on rappelle la possibilité d'assurer le passage en continu de la nappe de matériau à traiter depuis, par exemple, la pression atmosphérique jusqu'à la pression de travail, d'une manière contrôlée, sans glissement, sans étirement et avec une maîtrise contrôlée de l'étanchéité dynamique.

## Revendications

1. Dispositif d'introduction d'un matériau souple en bande dans une enceinte soumise à une différence de pressions ou de composition par rapport à l'atmosphère environnante, **caractérisé en ce qu'**il comprend des moyens(Bl) et (B2) aptes à assurer, en continu, le transfert et la mise en compression du matériau (M), d'une manière contrôlée, sans glissement et sans étirement, avec maîtrise de l'étanchéité dynamique à l'intérieur de l'enceinte ;
- lesdits moyens sont constitués par des bandes transporteuses (B1) et (B2) disposées en regard, en délimitant un espace (e) où est engagé le matériau (M) ;
- au moins les deux faces en regard de chacune des bandes présentant une série de cannelures identiques et régulièrement espacées pour être imbriquées en vue d'assurer, d'une manière concomitante, l'étanchéité dynamique dudit matériau sous l'effet de l'imbrication.

2. Dispositif selon la revendication 1, **caractérisé en ce que** chacune des face des bandes (B1) et (B2) présentent des cannelures.

3. Dispositif selon la revendication 1, **caractérisé en ce que** les bandes cannelées (B1) et (B2) coopèrent avec des organes d'entraînement en rotation pour être déplacées linéairement d'une manière continue.

4. Dispositif selon la revendication 3, **caractérisé en ce que** les organes d'entraînement sont constitués, pour chacune des bandes (B1) et (B2), par des rouleaux de renvoi et de mise en tension et par des rouleaux cannelés (4) et (5) assujettis à un organe moteur avec capacité d'indexation et de synchronisation.

5. Dispositif selon la revendication 1, **caractérisé en ce que** les bandes coopèrent avec un tunnel de guidage (14-27) présentant une sole fixe et une sole réglable pour faire varier, d'une manière correspondante, la pression d'écrasement exercée sur le matériau sous l'effet de l'imbrication des cannelures.

6. Application du dispositif selon l'une quelconque des revendications 1 à 5, à une installation de traitement sous vide comprenant :
- au moins une ensemble fermé (E) assujetti à des moyens d'aspiration pour obtenir, depuis la pression atmosphérique, une pression décroissante jusqu'à un poste de traitement soumis à la pression de travail ;
- les moyens de transfert et de mise en compression sont disposés à l'intérieur de l'ensemble (E), d'une manière étanche.

7. Installation comprenant un dispositif selon l'une quelconque des revendications 1 à 5 et les caractéristiques de l'installation mentionnée dans la revendication 6, **caractérisée en ce que** l'ensemble (E) est constitué de plusieurs modules ou étages alignés (M1, M2, M3 et M4) faisant office de sas et assujettis chacun à des moyens d'aspiration pour obtenir successivement une pression décroissante.

8. Installation comprenant un dispositif selon l'une quelconque des revendications 1 à 5 et les caractéristiques de l'installation mentionnée dans la revendication 6, **caractérisée en ce que** l'ensemble est constitué :
- d'une enceinte fermée (1) à partir de laquelle est introduit le matériau à la pression atmosphérique, ladite enceinte étant portée à une pression déterminée, et recevant, d'une manière étanche, les moyens de transfert et de mise en compression dudit matériau ;
- un module tampon (M1) avec rouleaux de guidage du matériau, ledit module étant porté à la même pression que l'enceinte ;
- au moins un module intermédiaire (M2) ;
- au moins un module (M4), avec rouleaux de guidage et d'entraînement, relié au poste de traitement ;
- l'enceinte et les différents modules étant agencés pour permettre le montage et le guidage des moyens de transfert et de mise en compression, d'une manière étanche et contrôlée.

## Claims

1. Device for inserting a flexible strip material into a chamber subjected to a difference in pressures or in composition with respect to the surrounding atmosphere, **characterized in that** it comprises means (B1) and (B2) capable of continuously ensuring the transfer and compression of the material (M) in a controlled way, without slip and without stretching, and with control of dynamic leaktightness inside the chamber;
- the said means consist of conveyor belts (B1) and (B2) arranged opposite one another, at the same time delimiting a space (e) into which the material (M) is engaged;
- at least the two opposite faces of each of the belts having a series of identical and uniformly spaced-apart grooves in order to be interleaved for the purpose of concomitantly ensuring the dynamic leaktightness of the said material under the effect of interleaving.

2. Device according to Claim 1, **characterized in that** each of the faces of the belts (B1) and (B2) has grooves.

3. Device according to Claim 1, **characterized in that** the grooved belts (B1) and (B2) cooperate with members for driving in rotation, in order to be displaced linearly in a continuous way.

4. Device according to Claim 3, **characterized in that** the drive members consist, for each of the belts (B1) and (B2), of return and tensioning rollers and of grooved rollers (4) and (5) controlled by a motor member having an indexing and synchronizing capability.

5. Device according to Claim 1, **characterized in that** the belts cooperate with a guide tunnel (14-27) having a fixed floor and an adjustable floor in order correspondingly to vary the crushing pressure exerted on the material under the effect of the interleaving of the grooves.

6. Use of the device according to any one of Claims 1 to 5, for a vacuum processing installation comprising:
- at least one closed assembly (E) subject to suction means in order to obtain, from atmospheric pressure, a pressure decreasing as far as a processing station subjected to the working pressure;
- the transfer and compression means are arranged inside the assembly (E) in a leaktight manner.

7. Installation comprising a device according to any one of Claims 1 to 5 and the characteristics of the installation mentioned in Claim 6, **characterized in that** the assembly (E) consists of a plurality of aligned modules or stages (M1, M2, M3 and M4) functioning as locks and each subject to suction means in order successively to obtain a decreasing pressure.

8. Installation comprising a device according to any one of Claims 1 to 5 and the characteristics of the installation mentioned in Claim 6, **characterized in that** the assembly consists:
- of a closed chamber (1) from which the material is inserted at atmospheric pressure, the said chamber being brought to a defined pressure and receiving in a leaktight manner the means for the transfer and compression of the said material;
- of a buffer module (M1) with rollers for guiding the material, the said module being brought to the same pressure as the chamber;
- of at least one intermediate module (M2);
- of at least one module (M4), with guide and drive rollers, which is connected to the processing station;
- the chamber and the various modules being arranged so as to make it possible to mount and guide the transfer and compression means in a leaktight and controlled manner.

## Patentansprüche

1. Vorrichtung zum Eintragen von weichelastischen Bändern in eine Kammer, die gegenüber der Umgebungsatmosphäre einem Druckgefälle oder einer Differenz in der Zusammensetzung ausgesetzt ist, **dadurch gekennzeichnet, dass** sie Elemente (B1) und (B2) aufweist, welche die kontinuierliche Übertragung und Komprimierung der Bänder (M) in kontrollierter Art und Weise ohne Rutschen und Dehnen und unter gieichzeitiger Beherrschung der dynamischen Dichtheit in der Kammer gewährleisten können;
- dass die Elemente aus Transportbändern (B1) und (B2) bestehen, die einander zugewandt sind, und einen Raum (e) begrenzen, in den die Bänder (M) eingreifen;
- dass mindestens die beiden Stirnflächen gegenüber jedem der Bänder eine Reihe identischer Rillen besitzen, die einen regelmäßigen Abstand zueinander aufweisen; so dass sie überlappen, um gleichzeitig die dynamische Dichtheit der Bänder unter der Wirkung der Überlappung zu gewährleisten.

2. Vorrichtung nach Anspruch 1, **dadurch gekennzeichnet, dass** jede Vorderseite der Bänder (B1) und (B2) Rillen besitzt.

3. Vorrichtung nach Anspruch 1, **dadurch gekennzeichnet, dass** die mit Rillen versehenen Bänder (B1) und (B2) mit sich drehenden Antriebsorganen zusammenwirken, so dass sie linear und kontinuierlich verschoben werden können.

4. Vorrichtung nach Anspruch 3, **dadurch gekennzeichnet, dass** die Antriebsorgane für jedes der Bänder (B1) und (B2) aus Umlenkrollen und Spannrollen sowie aus mit Rillen versehenen Rollen (4) und (5) bestehen, welche mit einem Motor mit Indexierungs- und Synchronisierungseigenschaften verbunden sind.

5. Vorrichtung nach Anspruch 1, **dadurch gekennzeichnet, dass** die Bänder mit einem Führungstunnel (14-27) zusammenwirken, der eine feststehende und eine verstellbare Sohle besitzt, um den Stauchdruck, der unter der Wirkung der Überlappung oder Verschachtelung der Rillen auf die Bänder ausgeübt wird, entsprechend zu variieren.

6. Anwendung der Vorrichtung nach einem der Ansprüche 1 bis 5 auf eine unter Vakuum stehende Verarbeitungsanlage mit:
- mindestens einer geschlossenen Einheit (E), welche mit Ansaugelementen verbunden ist, um ausgehend von dem Luftdruck bis zu der Verarbeitungsstation, die dem Arbeitsdruck unterworfen ist, einen Druckabfall zu erreichen;
- die Übertragungselemente und die Komprimierungselemente sind im Innern der Einheit (E) in undurchlässiger Art und Weise angeordnet.

7. Anlage mit einer Vorrichtung nach einem der Ansprüche 1 bis 5 und den Merkmalen der Anlage gemäß Anspruch 6, **dadurch gekennzeichnet, dass** die Einheit (E) aus mehreren justierten Modulen oder Stufen (M1, M2, M3 und M4) besteht, die als Schleuse dienen, und jeweils mit Ansaugelementen verbunden sind, um nach und nach einen Druckabfall zu erreichen.

8. Anlage mit einer Vorrichtung nach einem der Ansprüche 1 bis 5 und den Merkmalen der Anlage gemäß Anspruch 6, **dadurch gekennzeichnet, dass** die Einheit aus folgendem besteht:
- einer geschlossenen Kammer (1), in die die Bänder unter Luftdruck eingetragen werden, wobei die Kammer auf einen bestimmten Druck gebracht wird, und in undurchlässiger Art und Weise die Übertragungselemente und Elemente zur Komprimierung der Bänder aufnimmt;
- einem Puffermodul (M1) mit Führungsrollen für die Bänder, wobei der Modul auf den gleichen Druck gebracht wird wie die Kammer;
- mindestens einem Zwischenmodul (M2);
- mindestens einem Modul (M4) mit Führungs- und Antriebsrollen, die mit der Verarbeitungsstation verbunden sind;
- die Kammer und die verschiedenen Module sind so angeordnet, dass sie die Montage und die Führung von Übertragungselementen und Komprimierungselementen auf undurchlässige und kontrollierte Art und Weise erlauben.
